# EUROPEAN PATENT SPECIFICATION

(11) **EP 0 367 450 B1**
(45) Date of publication and mention of the grant of the patent: **21.12.1994**
(21) Application number: 89310759.9
(22) Date of filing: 19.10.1989
(51) Int. Cl.: G11C 5/14, G11C 11/408

(54) **Charge-retaining signal boosting circuit and method**
Verfahren und Ladungsfesthaltesignal-Erhöhungsschaltung
Méthode et circuit d'augmentation de signal de retenne de charge

(30) Priority: 31.10.1988 US 265366
(43) Date of publication of application: 09.05.1990
(73) Proprietor: TEXAS INSTRUMENTS INCORPORATED, Dallas Texas 75265 (US)
(72) Inventor: Love, Andrew M., Stafford Texas 77477 (US); Kersh, David V., III, Houston Texas 77036 (US)
(74) Representative: Legg, Cyrus James Grahame

(56) References cited:
- EP-A- 0 030 813
- US-A- 4 769 792
- PATENT ABSTRACTS OF JAPAN, vol. 10, no. 260 (P-494)[2316], 5th September 1986 & JP-A-61 85 699
- IBM TECHNICAL DISCLOSURE BULLETIN, vol. 28, no. 6, November 1985, pages 2660-2662, New York, US; "Simple wordline boosting circuit for high performance CMOS DRAMS"

## Description

### TECHNICAL FIELD OF THE INVENTION

The present invention relates in general to boosting a node in an integrated circuit to a voltage level above the supply voltage level, and more particularly relates to a method and apparatus for retaining a substantial amount of charge on a node boosting capacitor in a DRAM.

### BACKGROUND OF THE INVENTION

It is now common practice in dynamic random access memories (DRAMs) to boost a word line to above V_{dd} in order to store a full memory charge into the memory cells associated with the boosted word line during an "active restore" phase of the DRAM operation. It is often desirable in these and other integrated circuits to boost other nodes to above the V_{dd} or voltage supply level as well.

Driving and boosting heavily loaded signal lines, however, requires a large amount of power. In a conventional boosting design, a boosting capacitor is connected between the node to be boosted and a switched voltage supply source such as an internal signal that swings from zero volts to V_{dd}. The signal node to be boosted is first driven to V_{dd}. Then, the voltage supply is applied to one electrode of the boosting capacitor, thus capacitively coupling the other electrode of the capacitor to a voltage level boosted above V_{dd}. Since this second electrode is connected directly to the signal node, the signal node also is boosted above the V_{dd} level.

One disadvantage of this method is that the large boosting capacitor generally required is completely charged and discharged during every cycle of operation, thus consuming large amounts of power. Another disadvantage is that the charging of the signal node is slowed because the boosting capacitor is permanently connected thereto, thereby adding to the RC time constant.

One conventional solution to the above problem is to connect the boosting capacitor to the signal node through a transistor whose gate is then boosted at an appropriate time by a second capacitor. As will be described in more detail below, this conventional solution stores a less than optimum voltage level on the boosting capacitor during the reset phase of the operation cycle. A need has therefore arisen for a node-boosting circuit that will isolate the boosting capacitor from the signal node while the node is charging to V_{dd}, while at the same time allowing the storage of a higher voltage level across the boosting capacitor during the reset phase of the operation cycle.

### SUMMARY OF THE INVENTION

According to one aspect of the present invention there is provided apparatus for preserving a predetermined voltage level near a voltage supply level on a boosting capacitor, comprising:
a transistor having a current path and a control electrode, said current path being operable to couple a first electrode of said boosting capacitor to a signal node;
first circuitry for boosting the voltage on said signal node to a boosted level above the voltage supply level through said transistor;
second circuitry for discharging a second electrode of said boosting capacitor to a first voltage level so that charge is withdrawn from said signal node through said transistor to said first electrode and a second voltage level exists on said first electrode, said capacitor storing said predetermined voltage level substantially equivalent to the difference between said first and second voltage levels; and
third circuitry for discharging said control electrode to below a threshold voltage of said transistor so that said capacitor is isolated from said signal node and said stored predetermined voltage level is maintained on said capacitor for an extended period of time.

According to a second aspect of the present invention there is provided a method of preserving a predetermined voltage level near a voltage supply level on a boosting capacitor comprising the steps of:
boosting the voltage at a node to a boosted level substantially above the voltage supply level;
discharging a second electrode of the boosting capacitor to a first voltage level;
withdrawing charge from the node through a transistor to a first electrode of the boosting capacitor responsive to said step of discharging the second electrode thereby establishing a second voltage level on the first electrode, the first voltage level being chosen such that the difference between the first voltage level and the second voltage level is equal to or slightly greater than the predetermined voltage level; and
thereafter discharging the control electrode of the transistor to a voltage level below the threshold voltage of the transistor to isolate the boosting capacitor from the node, so that the predetermined voltage level is maintained across the boosting capacitor for an extended length of time.

One embodiment of the invention comprises an apparatus for boosting a node to a first voltage level substantially above a voltage supply level. A transistor has a current path that is used to selectively couple the first electrode of a boosting capacitor to the node. A first circuit is provided for boosting the control electrode of the transistor to a voltage level that is also substantially above the voltage supply level. A second circuit that includes the boosting capacitor boosts the node to the first, boosted voltage level by raising a second electrode of the boosting capacitor to a voltage near the voltage supply level sometime after the first circuit boosts the control electrode of the transistor A third circuit discharges the second electrode of the boosting capacitor to a voltage level substantially lower than the voltage supply level at a time after the node is boosted. This causes the withdrawal of charge from the node through the current path to the first electrode of the boosting capacitor, and maintains a second voltage level across the boosting capacitor that is near the voltage supply level. A fourth circuit next discharges the control electrode of the transistor to a voltage level below the threshold operating voltage of the transistor, such that a third voltage level will be maintained across the boosting capacitor electrodes for an extended period of time.

In another embodiment of the invention, the first circuit that boosts the control electrode of the transistor includes a second capacitor. The boosting of the control electrode of the transistor is effected by impressing a supply voltage level on one electrode of the second capacitor, and boosting the second electrode of the second capacitor to an elevated level by capacitive coupling, which elevated level is applied to the control electrode of the transistor. Both electrodes of the second capacitor are discharged at the time that the control electrode of the transistor is discharged.

A principal advantage of the present invention is its independent control of the second capacitor and the boosting capacitor. A boosted level is allowed to be maintained at the control electrode or gate of the pass transistor while one electrode of the boosting capacitor is discharged. This pulls charge off of the signal node and back through the transistor current path onto the boosting capacitor. This charge transfer helps to discharge the signal node while at the same time allowing the saving of almost a full V_{dd} charge on the boosting capacitor. The gate electrode of the transistor is then discharged, thus isolating the boosting capacitor from the node and maintaining this charge until the next operating cycle.

### BRIEF DESCRIPTION OF THE DRAWINGS

The aspects of the invention and their advantages will be discerned from the following detailed description taken in conjunction with the drawings in which:
FIGURE 1 is an electrical schematic diagram of a prior art signal node boosting circuit;
FIGURES 2a-2d are timing diagrams of various nodes within the circuit illustrated in FIGURE 1, showing the operation thereof;
FIGURE 3 is an electrical schematic diagram of a signal node boosting circuit according to the invention; and
FIGURES 4a-4e are timing diagrams showing voltage levels at various nodes in the circuit of FIGURE 3 during active and reset cycles of operation thereof.

### DETAILED DESCRIPTION OF THE INVENTION

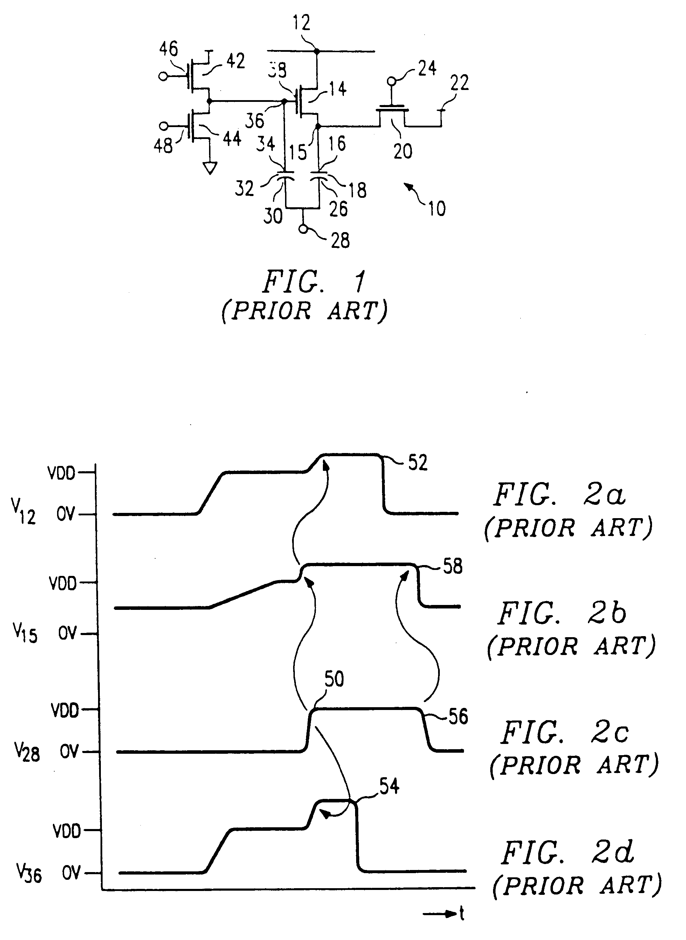

A prior art boosting circuit is indicated generally at 10 in FIGURE 1. The circuit 10 is coupled to a signal node 12, which for example can be a signal line. More particularly, signal node 12 can be connected to a row line in a dynamic random access memory (DRAM) through a row decoder pass gate (not shown), which row line will have a plurality of memory cells (not shown) coupled thereto. In this last case, it is important to boost the voltage of the row line 12 above the supply voltage or V_{dd} in order to assure the storage of a full V_{dd} inside certain capacitors (not shown) of the memory cells.

A current path of an n-channel field-effect transistor 14 is operable to connect the signal node 12 to a first electrode 16 of a boosting capacitor 18. The electrode 16 is also connected through a switching transistor 20 to a voltage supply 22 such as V_{dd}. The switching transistor 20 has a gate 24 connected to a control signal source (not shown).

A second electrode 26 of the boosting capacitor 18 is connected to a control signal node 28. A control circuit (not shown) is capable of impressing V_{dd} on the electrode 26 through node 28, and is further capable of discharging the electrode 26 to ground, at different predetermined times. The construction of such a control circuit is conventional, and is therefore not described here.

The control signal node 28 is further connected to an electrode 30 of a second capacitor 32. An opposed electrode 34 of capacitor 32 is connected to a node 36. Node 36 is connected to a gate 38 of the transistor 14, it is connected to V_{dd} through an NMOS transistor 42, and it is connected to ground through a further NMOS transistor 44. A gate 46 of the transistor 42 is connected to a signal source (not shown) that is capable of selectively impressing a voltage level on the gate 46 that substantially exceeds V_{dd}. A gate 48 of the transistor 44 is controlled by a signal source (not shown) that is capable of actuating the transistor 44 to pull node 36 to ground.

The operation of this prior art boosting circuit can be best described in conjunction with FIGURES 2a-2d, which are timing diagrams of signal node 12, boosting node 15, control node 28 and gate node 36 within the circuit of FIGURE 1 during precharge, active and reset portions of a DRAM operating cycle. The diagrams show voltage versus time, with V_{dd} typically being about 5 volts. The time for an entire operation cycle is typically about 100 nanoseconds.

During a precharge phase of operation, the transistor 14 is off and a charge of approximately one-half of V_{dd} exists across the electrodes 16 and 26 of the capacitor 18. In an active phase following the precharge phase, the node 15 is driven slowly to V_{dd} by the actuation of transistor 20 by a higher-than-V_{dd} control signal at terminal 24. At about the same time, the gate node 36 is raised to V_{dd} through the action of a boosted signal on the gate 46 of the transistor 42, and signal node 12 is driven to V_{dd}.

At a time 50, the control node 28 is raised from zero volts to V_{dd}, and thus V_{dd} will exist at the electrodes 26 and 30. This in turn causes an elevated voltage to appear on the electrodes 16 and 34 of respective capacitors 18 and 32 through capacitive coupling.

Voltages elevated above V_{dd} will therefore appear at nodes 15 and 36. The elevated voltage impressed on the gate 38 of the transistor 14 will in turn allow the transmission of an elevated voltage level onto the signal node 12. In the case where V_{dd} is 5 volts, for example, the elevated voltage may be approximately 7.5 volts.

The signal node 12 and the gate node 36 are next discharged to ground at respective times 52 and 54. At a later time 56, the voltage at node 28 is dropped from V_{dd} to zero volts, which in turn discharges the electrodes 26 and 30 to ground. The capacitor 18 is allowed to remain charged to a voltage equal to the difference between the boosted voltage level that had existed at node 12 and V_{dd}, which in turn is approximately equal to one-half of V_{dd}. Therefore, the voltage with respect to ground of node 15 will fall to one-half V_{dd} as is shown at 58. A disadvantage of this prior art method is that only approximately one-half of the voltage supply level is allowed to be stored across the electrodes 16 and 26 of the boosting capacitor 18.

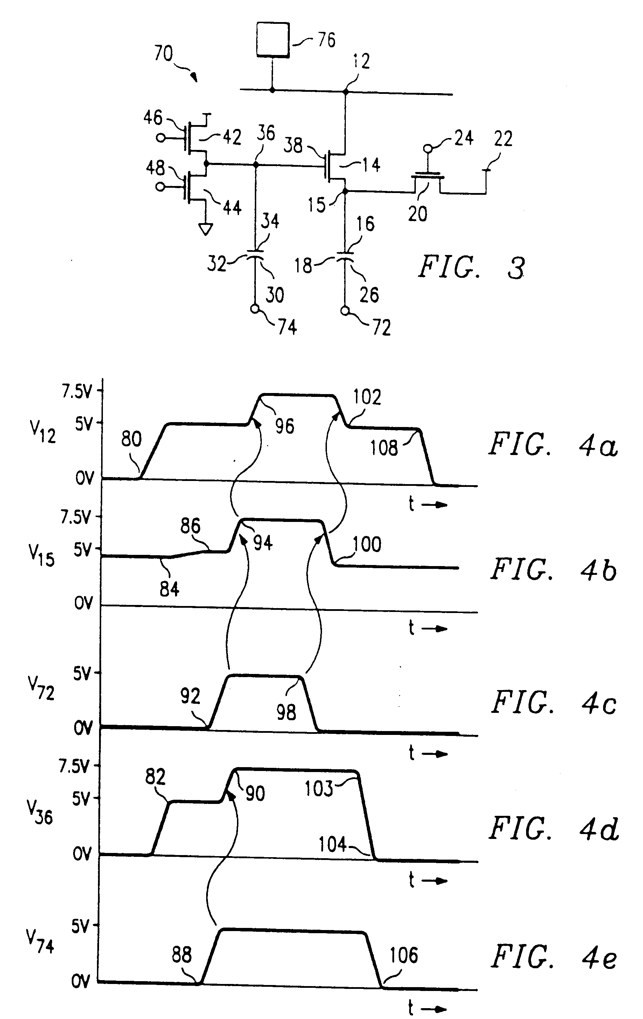

Turning now to FIGURE 3, a detailed electrical schematic diagram is shown of the invention's boosting circuit indicated generally at 70. The circuit of FIGURE 3 is somewhat similar to that shown in FIGURE 1, and therefore like numbers have been used to identify like parts wherever possible. A description of the main structural differences between the circuits shown in FIGURES 1 and 3 will suffice.

In FIGURE 3, a first control signal is applied through a control signal node 72 and a second control signal is applied through a signal node 74. Control signal generating circuitry (not shown) of conventional design is connected to node 24, gates 46 and 48, and nodes 72, 74 and control circuit 76 to impress different control signals thereon at preselected times. This generating circuitry may include a controller for generating a plurality of drive signals and for controlling a plurality of switching transistors connected to respective ones of the nodes 24, 46, 48, 72, 74 and 12 that are actuated by the drive signals. The control signal node 72 is connected only to the second electrode 26 of the boosting capacitor 18, while control signal node 74 is connected only to the second electrode 30 of the second capacitor 32. The control signals transmitted through nodes 72 and 74 are operated independently, as will be further explained in conjunction with FIGURES 4a-4e.

FIGURES 4a-4e set out a series of timing diagrams that show the voltage levels at nodes 12, 15, 72, 36 and 74, respectively, during the reset and active cycles of operation of the circuit. The voltage at node 15 begins at approximately 4.5 volts as an effect from the charging of the boosting capacitor 18 from the prior cycle. Node 12 begins in a discharged condition at zero volts, as do nodes 72, 36 and 74.

At a time 80, the voltage level at the signal node 12 begins to be raised to five volts, or V_{dd}, through a drive signal source 76 connected to node 12. The voltage at node 36 begins to rise at a time 82 that may be at or slightly after time 80. The voltage level at node 36 will appear at transistor gate 38 and electrode 34. V_{dd} appears at node 36 by means of the application of a boosted voltage level to the gate 46 of the transistor 42.

Control signal 24 is boosted to a voltage above V_{dd} at time 84 (see FIGURE 4b), which causes node 15 to begin to rise to a full V_{dd} level. The charge up to a full V_{dd} is completed at a time 86.

At a time before time 88 (FIGURE 4e), the gate 46 of transistor 42 and the gate 24 of transistor 20 are discharged from their boosted states to V_{dd}, or more preferably ground. Then, at a time 88 shortly after time 86, the voltage at the control signal node 74 is raised from 0 volts to 5 volts, in turn causing the occurrence of a boosted voltage at node 36 by capacitive coupling at time 90. At a time 92 that may be simultaneous with time 88, the voltage at node 72 begins to be raised from 0 to 5 volts, in turn causing an elevated level to appear at the node 15 by capacitive coupling at a time 94. Once both times 90 and 94 have been reached, a boosted voltage level will begin to be communicated to the signal node 12, and a boosted voltage level will be fully achieved by a time 96.

A reset portion of the cycle begins on or before a time 98, at which point the control signal node 72 begins to be pulled down from 5 volts to ground. The discharge of the capacitor electrode 26 in turn causes a drop of the voltage level at the node 15 by a time 100 to a level slightly below V_{dd} by capacitive coupling. This in turn causes the withdrawal of charge from the signal node 12 through the current path of the transistor 14 to the node 15. The signal node 12 will therefore be back at approximately V_{dd} by a time 102. The withdrawal of charge off of the signal node 12, however, allows the maintenance of an almost full V_{dd} voltage level across the electrodes 16 and 26 of the boosting capacitor 18. In another embodiment, node 72 may be pulled down to a voltage other than ground such that the stored voltage is other than V_{dd}.

The voltage at the node 36 is next discharged to ground through the grounding transistor 44 at a time 104, which is after time 102. This causes the first electrode 34 of the second capacitor 32, as well as the gate 38 of the transistor 14, to become discharged. At a time 106 that is after time 102 and which may be simultaneous with the time 104, the node 74 is discharged, thereby discharging the capacitor electrode 30. The charging and discharging of the second capacitor 32 is not expensive in terms of power since it is much smaller than the principal boosting capacitor 18.

The discharging of the gate node 36 turns off the transistor 14 and thus isolates the node 15 from the signal node 12. At a time 108, therefore, the node 12 may be discharged back to zero without affecting the voltage level that exists across the boosting capacitor 18. The voltage appearing across electrodes 16 and 26, which is at this point the same as the voltage with respect to ground of node 15, will be approximately 4.5 volts. If five or ten nanoseconds are added to the cycle between time 98 and time 103, a full V_{dd} could be stored on the boosting capacitor 18.

It can be seen that the dissipation of large amounts of power in the charging and recharging of the boosting capacitor 18 has been avoided. Since the boosting capacitor 18 is isolated from the signal node 12, the signal node 12 can be driven high faster.

In an alternative embodiment (not shown), two or more circuits 70 may be coupled to the node 12 instead of just one. For example, during a first cycle, a first of these circuits 70 would be used to boost node 12 and a second circuit 70 would draw charge from the node 12 for its boosting capacitor 16. The roles would then be reversed for the second cycle.

In summary, an advantageous boosting circuit has been disclosed that allows the preservation of almost a full V_{dd} across the boosting capacitor by its independent boosting control of the gate of the pass gate transistor that connects the boosting capacitor to the signal node. The present invention has application to any node that is required to be boosted above an integrated circuit voltage supply level. Therefore, while one illustrated embodiment has been described above together with its advantages, the invention is not limited thereto but only by the appended claims.

## Claims

1. Apparatus for preserving a predetermined voltage level near a voltage supply level (V_{dd}) on a boosting capacitor (18), comprising:
a transistor (14) having a current path and a control electrode (38), said current path being operable to couple a first electrode (16) of said boosting capacitor (18) to a signal node (12);
first circuitry for boosting the voltage on said signal node (12) to a boosted level above the voltage supply level through said transistor (14);
second circuitry (72) for discharging a second electrode (26) of said boosting capacitor (18) to a first voltage level (GND) so that charge is withdrawn from said signal node (12) through said transistor (14) to said first electrode (16) and a second voltage level exists on said first electrode, said capacitor (18) storing said predetermined voltage level substantially equivalent to the difference between said first and second voltage levels; and
third circuitry (74,44,46) fór discharging said control electrode (38) to below a threshold voltage of said transistor (14) so that said capacitor (18) is isolated from said signal node and said stored predetermined voltage level is maintained on said capacitor (18) for an extended period of time.

2. Apparatus as claimed in claim 1 wherein said first circuitry includes a first circuit for boosting said control electrode (38) of said transistor (14) to a voltage above said supply level.

3. Apparatus as claimed in claim 2 wherein said first circuit comprises a second capacitor (32), a first electrode (34) of said second capacitor (32) being coupled to said control electrode (38) of said transistor (14), and a second electrode (30) of said second capacitor (32) being selectively coupled to a voltage supply; said first circuit being operable to connect said voltage supply to said second electrode (30) of said second capacitor (32) so that said first electrode (34) of said second capacitor (32) and said control electrode (38) are capacitively coupled to said voltage level above said voltage supply level.

4. Apparatus as claimed in claim 3 wherein said first circuit further comprises a discharge circuit for discharging said second electrode (30) of said second capacitor (32) so that said control electrode (38) of said transistor (14) and said first electrode (34) of said second capacitor (32) become capacitively coupled down to a voltage level near said supply level.

5. Apparatus as claimed in any preceding claim wherein a cycle of operation of said apparatus includes active and reset phases, a voltage level being retained by said boosting capacitor (18) after said control electrode (38) of said transistor (14) has been discharged by said third circuitry during said reset phase, the last said voltage level persisting until said first circuitry boosts the voltage level on said signal node (12) during the active phase of the next operation cycle.

6. Apparatus as claimed in any preceding claim wherein said first circuitry comprises a switch (20) for selectively coupling said voltage supply to said first electrode (16) of said boosting capacitor (18).

7. Apparatus as claimed in any preceding claim wherein said second voltage level is about 0 V.

8. Apparatus as claimed in any preceding claim wherein said first voltage level is approximately 1.5 times the magnitude of said voltage supply level.

9. Apparatus as claimed in any preceding claim wherein said node (12) is a conductor for transmitting a drive/boot signal to a plurality of row line circuits.

10. Apparatus as claimed in any preceding claim, further comprising fourth circuitry for charging the second electrode (26) of said boosting capacitor (18) to said voltage supply level.

11. Apparatus as claimed in claim 10, further comprising fifth circuitry for charging said node (12) to said voltage supply level.

12. Apparatus as claimed in any preceding claim, further comprising circuitry for discharging said node (12) after isolation of said boost capacitor (18).

13. Apparatus as claimed in claims 2 to 12, wherein said first circuit is operable to bring said control electrode (38) of said transistor (14) to said supply voltage level prior to the boosting thereof.

14. An integrated circuit including apparatus as claimed in any preceding claim.

15. An integrated circuit according to claim 14, wherein said integrated circuit comprises a dynamic random access memory.

16. An integrated circuit according to claim 14 or 15, wherein said node (12) is coupled to a row line in turn coupled to a plurality of memory cells.

17. An integrated circuit according to claim 14, 15 or 16, wherein said voltage supply level is about five volts, said boosting capacitor (18) is operable to retain a voltage level of about 4.5 volts after said control electrode (38) of said transistor (14) has been discharged.

18. A method of preserving a predetermined voltage level near a voltage supply level (V_{dd}) on a boosting capacitor (18) comprising the steps of:
boosting the voltage at a node (12) to a boosted level substantially above the voltage supply level;
discharging a second electrode (26) of the boosting capacitor (18) to a first voltage level (gnd);
withdrawing charge from the node (12) through a transistor (14) to a first electrode (16) of the boosting capacitor (18) responsive to said step of discharging the second electrode (26) thereby establishing a second voltage level on the first electrode (16), the first voltage level being chosen such that the difference between the first voltage level and the second voltage level is equal to or slightly greater than the predetermined voltage level; and
thereafter discharging the control electrode (38) of the transistor (14) to a voltage level below the threshold voltage of the transistor (14) to isolate the boosting capacitor (18) from the node (12), so that the predetermined voltage level is maintained across the boosting capacitor (18) for an extended length of time.

19. A method as claimed in claim 18, further including the steps of:
raising a second electrode (30) of a second capacitor (32) to the voltage supply level;
in response to said step of raising the voltage level on said second electrode (30), boosting the voltage level of a first electrode (34) of the second capacitor (32) to a boosted level above the voltage supply level; and
transmitting the boosted level from the first electrode (34) of the second capacitor (32) to the control electrode (38) of the transistor (14) so that the current may flow between the boosting capacitor (18) and the node (12).

20. A method as claimed in claim 18 or claim 19, further comprising the step of bringing the voltage level of said control electrode (38) to the voltage supply level prior to said step of boosting the voltage level on said control electrode (38).

21. A method as claimed in any of claims 19 to 20, wherein said step of boosting the node voltage further comprises the step of raising the voltage level of a second electrode (26) of the boosting capacitor (18) to the voltage supply level in order to boost the voltage level of the first electrode (16) thereof above the voltage supply level.

22. A method as claimed in any of claims 18 to 21, further comprising the step of:
bringing the node voltage to the voltage supply level; and
subsequently boosting the voltage on the control electrode (38) of the transistor (14) to permit the boosted level to be transferred to the node (12).

23. A method as claimed in any of claims 18 to 22, further comprising the step of bringing the first electrode (16) of the boosting capacitor (18) to the voltage supply level prior to said step of boosting the node voltage.

24. A method as claimed in any of claims 18 to 23, comprising the step of discharging the node (12) after said step of discharging the transistor control electrode (38).

## Patentansprüche

1. Vorrichtung zum Erhalten eines vorbestimmten Spannungspegels nahe einem Versorgungsspannungspegel (V_{dd}) an einem Erhöhungskondensator (18), mit:
einein, einen Stromweg und eine Steuerelektrode (38) aufweisenden Transistor (14), wobei über den Stromweg die erste Elektrode (16) des Erhöhungskondensators (18) einem Signalknoten (12) koppelbar ist;
einer ersten Schaltung zum Erhöhen der Spannung an dem Signalknoten (12) auf einen erhöhten Pegel oberhalb dem Versorgungsspannungspegel über den Transistor (14);
einer zweiten Schaltung (72) zum Entladen einer zweiten Elektrode (26) des Erhöhungskondensators (18) auf einen ersten Spannungspegel (GND), so daß eine Ladung von dem Signalknoten (12) über den Transistor (14) zu der ersten Elektrode (16) abgezogen wird und ein zweiter Spannungspegel an der ersten Elektrode vorliegt, wobei der Kondensator (18) den vorbestimmten Spannungspegel speichert, der im wesentlichen gleichwertig mit der Differenz zwischen dem ersten Spannungspegel und dem zweiten Spannungspegel ist; und
einer dritten Schaltung (74, 44, 46) zum Entladen der Steuerelektrode (38) unter eine Schwellenspannung des Transistors (14), so daß der Kondensator (18) gegenüber dem Signalknoten isoliert ist und der gespeicherte vorbestimmte Spannungspegel an dem Kondensator (18) für eine verlängerte Zeitdauer aufrechterhalten wird.

2. Vorrichtung nach Anspruch 1, bei der die erste Schaltung einen ersten Schaltkreis enthält, um die Steuerelektrode (38) des Transistors (14) auf eine Spannung oberhalb dem Versorgungspegel anzuheben.

3. Vorrichtung nach Anspruch 2, bei der der erste Schaltkreis einen zweiten Kondensator (32) enthält, wobei eine erste Elektrode (34) des zweiten Kondensators (32) mit der Steuerelektrode (38) des Transistors (14) gekoppelt ist und eine zweite Elektrode (30) des zweiten Kondensators (32) wahlweise mit einer Versorgungsspannung gekoppelt ist; wobei über den ersten Schaltkreis die Versorgungsspannung an die zweite Elektrode (30) des zweiten Kondensators (32) anschließbar ist, so daß die erste Elektrode (34) des zweiten Kondensators (32) und die Steuerelektrode (38) kapazitiv mit dem Spannungspegel oberhalb dem Versorgungsspannungspegel gekoppelt sind.

4. Vorrichtung nach Anspruch 3, bei der der erste Schaltkreis zudem einen Entladungskreis zum Entladen der zweiten Elektrode (30) des zweiten Kondensators (32) enthält, so daß die Steuerelektrode (38) des Transistors (14) und die erste Elektrode (34) des zweiten Kondensators (32) kapazitiv auf einen Spannungspegel nahe dem Versorgungspegel heruntergekoppelt werden.

5. Vorrichtung nach einem der vorhergehenden Ansprüche, bei der ein Betriebszyklus der Vorrichtung eine aktive und eine Rücksetzphase enthält, wobei ein Spannungspegel durch den Erhöhungskondensator (18) beibehalten wird, nachdem die Steuerelektrode (18) des Transistors (14) durch die dritte Schaltung während der Rücksetzphase entladen wurde, wobei der zuletzt genannte Spannungspegel bestehen bleibt, bis die erste Schaltung den Spannungspegel an dem Signalknoten (12) während der aktiven Phase des nächsten Betriebszyklus erhöht

6. Vorrichtung nach einem der vorhergehenden Ansprüche, bei der die erste Schaltung einen Schalter (20) enthält, um wahlweise die Versorgungsspannung mit der ersten Elektrode (16) des Erhöhungskondensators (18) zu koppeln.

7. Vorrichtung nach einem der vorhergehenden Ansprüche, bei der der zweite Spannungspegel bei etwa 0 V liegt.

8. Vorrichtung nach einem der vorhergehenden Ansprüche, bei der der erste Spannungspegel etwa 1,5mal so groß Wie der Versorgungsspannungspegel ist.

9. Vorrichtung nach einem der vorhergehenden Ansprüche, bei der der Knoten (12) ein Leiter zum Übertragen eines Treiber, Erhöhungs-Signals zu einer Mehrzahl von Zeilenleitungs schaltkreisen ist.

10. Vorrichtung nach einem der vorhergehenden Ansprüche, die ferner eine vierte Schaltung enthält, um die zweite Elektrode (26) des Erhöhungskondensators (18) auf den Versorgungsspannungspegel zu laden.

11. Vorrichtung nach Anspruch 10, die ferner eine fünfte Schaltung enthält, um den Knoten (12) auf den Versorgungsspannunggpegel zu laden.

12. Vorrichtung nach einem der vorhergehenden Ansprüche, die ferner eine Schaltung enthält, um den Knoten (12) nach dem Isolieren des Erhöhungskondensators (18) zu entladen,

13. Vorrichtung nach den Ansprüchen 2 bis 12, bei der erste Schaltkreis imstande ist, die Steuerelektrode (38) des Transistors (14) auf den Versorgungsspannungspegel zu bringen, bevor diese erhöht wird.

14. Integrierte Schaltung mit einer Vorrichtung nach einem der vorhergehenden Ansprüche.

15. Integrierte Schaltung nach Anspruch 14, wobei die integrierte Schaltung einen dynamischen RAM-Speicher enthält.

16. Integrierte Schaltung nach Anspruch 14 oder 15, bei der der Knoten (12) mit einer Zeilenleitung gekoppelt ist, die wiederum mit einer Mehrzahl von Speicherzellen gekoppelt ist.

17. Integrierte Schaltung nach Anspruch 14, 15 oder 16, bei der der Versorgungsspannungspegel über fünf Volt liegt, wobei der Erhöhungskondensator (18) imstande ist, einen Spannungspegel von etwa 4,5 Volt beizubehalten, nachdem die Steuerelektrode (38) des Transistors (14) entladen wurde.

18. Verfahren zum Erhalten eines vorbestimmten Spannungspegels nahe einem Versorgungsspannungspegel (V_{dd}) an einem Erhöhungskondensator (18), das die folgenden Schritte enthält:
Erhöhen der Spannung an einem Knoten (12) auf einen erhöhten Pegel deutlich oberhalb des Versorgungsspannungspegels;
Entladen einer zweiten Elektrode (26) des Erhöhungskondensators (18) auf einen ersten Spannungspegel (gnd);
Abziehen einer Ladung von dem Knoten (12) über einen Transistor (14) zu einer ersten Elektrode (16) des Erhöhungskondensators (18) in Reaktion auf den Schritt des Entladens der zweiten Elektrode (26), wodurch an der ersten Elektrode (16) ein zweiter Spannungspegel hervorgerufen wird, wobei der erste Spannungspegel so gewählt wird, daß die Differenz zwischen dem ersten Spannungspegel und dem zweiten Spannungspegel gleich oder etwas größer als der vorbestimmte Spannungspegel ist; und
anschließendes Entladen der Steuerelektrode (38) des Transistors (14) auf einen Spannungspegel unterhalb der Schwellenspannung des Transistors (14), um den Erhöhungskondensator (18) von dem Knoten (12) zu isolieren, so daß der vorbestimmte Spannungspegel für eine verlängerte Zeitdauer über dem Erhöhungskondensator (18) aufrechterhalten wird.

19. Verfahren nach Anspruch 18, das ferner die folgenden Schritte enthält:
Anheben einer zweiten Elektrode (30) eines zweiten Kondensators (32) auf den Versorgungsspannungsegel;
Erhöhen des Spannungspegels einer ersten Elektrode (34) des zweiten Kondensators (32) auf einen erhöhten Pegel oberhalb dem Versorgungsspannungspegel in Reaktion auf den Schritt des Anhebens des Spannungspegel an der zweiten Elektrode (30); und
Übertragen des erhöhten Pegels von der ersten Elektrode (34) des zweiten Kondensators (32) zu der Steuerelektrode (38) des Transistors (14), so daß der Strom zwischen dem Erhöhungskondensator (18) und dem Knoten (12) fließen kann.

20. Verfahren nach Anspruch 18 oder 19, das ferner den Schritt enthält, wonach der Spannungspegel der Steuerelektrode (38) vor dem Schritt des Erhöhens des Spannungspegels an der Steuerelektrode (38) auf den Versorgungsspannungspegel gebracht wird.

21. Verfahren nach Anspruch 19 oder 20, bei dem der Schritt des Erhöhens der Knotenspannung ferner den Schritt enthält, wonach der Spannungspegel einer zweiten Elektrode (26) des Erhöhungskondensators (18) auf den Versorgungsspannungspegel angehoben wird, um den Spannungspegel von dessen erster Elektrode (16) über den Versorgungsspannungspegel zu erhöhen.

22. Verfahren nach einem der Ansprüche 18 bis 21, das ferner den Schritt enthält, wonach:
die Knotenspannung auf den Spannungsversorgungspegel gebracht wird; und
anschließend die Spannung an der Steuerelektrode (38) des Transistors (14) erhöht wird, damit der erhöhte Pegel zu dem Knoten (12) übertragen werden kann.

23. Verfahren nach einem der Ansprüche 18 bis 22, das ferner den Schritt enthält, wonach die erste Elektrode (16) des Erhöhungskondensators (18) vor dem Schritt des Erhöhens der Knotenspannung auf den Versorgungsspannungspegel gebracht wird.

24. Verfahren nach einem der Ansprüche 18 bis 23, das den Schritt enthält, wonach der Knoten (12) nach dem Schritt des Entladens der Transistor-Steuerelektrode (38) entladen wird.

## Revendications

1. Appareil pour conserver un niveau de tension prédéterminé proche d'un niveau d'alimentation de tension (VDD) aux bornes d'un condensateur de surtension (18), comprenant:
- un transistor (14) ayant un trajet de courant et une électrode de commande (38), ledit trajet de courant étant adapté pour relier une première électrode (16) dudit condensateur de surtension (18) à un noeud de signal (12) ;
- un premier circuit pour élever la tension dudit noeud de signal (12) jusqu'à un niveau de surtension au dessus du niveau d'alimentation de tension à travers ledit transistor (14) ;
- un second circuit (72) pour décharger une seconde électrode (26) dudit condensateur de surtension (18) jusqu'à un premier niveau de tension (TERRE) de telle sorte qu'une charge soit extraite dudit noeud de signal (12) à travers ledit transistor (14) vers ladite première électrode (16) et qu'un second niveau de tension soit présent sur ladite première électrode, ledit condensateur (18) mémorisant ledit niveau de tension prédéterminé approximativement proche de la différence entre lesdits premier et second niveaux de tension ; et
- un troisième circuit (74,44,46) pour décharger ladite électrode de commande (38) jusqu'à un niveau inférieur à une tension de seuil dudit transistor (14) de telle sorte que ledit condensateur (18) soit isolé dudit noeud de signal et que ledit niveau de tension prédéterminé soit maintenu sur ledit condensateur (18) pendant une période de temps étendue.

2. Appareil selon la revendication 1, dans lequel ledit premier circuit comporte un premier circuit pour augmenter la tension de ladite électrode de commande (38) dudit transistor (14) jusqu'à une tension supérieure audit niveau d'alimentation.

3. Appareil selon la revendication 2, dans lequel ledit premier circuit comporte un second condensateur (32), une première électrode (34) dudit second condensateur (32) étant reliée à ladite électrode de commande (38) dudit transistor (14), et une seconde électrode (30) dudit second condensateur (32) étant reliée de façon sélective à une alimentation de tension ; ledit premier circuit étant adapté pour relier ladite alimentation de tension à ladite seconde électrode (30) dudit second condensateur (32) de telle sorte que ladite première électrode (34) dudit second condensateur (32) et ladite électrode de commande (38) soient reliées par un couplage capacitif audit niveau de tension au dessus dudit niveau d'alimentation de tension.

4. Appareil selon la revendication 3, dans lequel ledit premier circuit comporte de plus un circuit de décharge pour décharger ladite seconde électrode (30) dudit second condensateur (32) de telle sorte que ladite électrode de commande (38) dudit transistor (14) et ladite première électrode (34) dudit second condensateur (32) deviennent reliées par un couplage capacitif à un niveau de tension proche dudit niveau d'alimentation.

5. Appareil selon l'une quelconque des revendications précédentes, dans lequel un cycle de fonctionnement dudit appareil comporte des phases active et de réinitialisation, un niveau de tension étant conservé par ledit condensateur de surtension (18) après que ladite électrode de commande (38) dudit transistor (14) a été déchargée par ledit troisième circuit pendant ladite phase de réinitialisation, le dernier niveau de tension persistant jusqu'à ce que ledit premier circuit augmente le niveau de tension dudit noeud de signal (12) pendant la phase active du cycle de fonctionnement suivant.

6. Appareil selon l'une quelconque des revendications précédentes, dans lequel ledit premier circuit comporte un commutateur (20) pour relier de façon sélective ladite alimentation de tension à ladite première électrode (16) dudit condensateur de surtension (18).

7. Appareil selon l'une quelconque des revendications précédentes, dans lequel second niveau de tension est approximativement de zéro Volt.

8. Appareil selon l'une quelconque des revendications précédentes, dans lequel ledit premier niveau de tension est approximativement de l'ordre d'une fois et demi l'amplitude dudit niveau d'alimentation de tension.

9. Appareil selon l'une quelconque des revendications précédentes, dans lequel ledit noeud (12) est un conducteur pour transmettre un signal de commande/démarrage à une pluralité de circuits de lignes de rangées.

10. Appareil selon l'une quelconque des revendications précédentes, comprenant de plus un quatrième circuit pour charger la seconde électrode (26) dudit condensateur de surtension (18) jusqu'audit niveau d'alimentation de tension.

11. Appareil selon la revendication 10, comportant de plus un cinquième circuit pour charger ledit noeud (12) jusqu'audit niveau d'alimentation de tension.

12. Appareil selon l'une quelconque des revendications précédentes, comprenant de plus un circuit pour décharger ledit noeud (12) après l'isolation dudit condensateur de surtension (18).

13. Appareil selon l'une quelconque des revendications 2 à 12, dans lequel ledit premier circuit est adapté pour amener ladite électrode de commande (38) dudit transistor (14) jusqu'audit niveau d'alimentation préalablement à son élévation de tension.

14. Circuit intégré comportant un appareil selon l'une quelconque des revendications précédentes.

15. Circuit intégré selon la revendication 14, dans lequel ledit circuit intégré comporte une mémoire vive dynamique.

16. Circuit intégré selon l'une des revendications 14 et 15, dans lequel ledit noeud (12) est relié à une ligne de rangée à son tour reliée à une pluralité de cellules mémoires.

17. Circuit intégré selon la revendication 14,15 ou 16, dans lequel ledit niveau d'alimentation est d'environ de 5 volts, ledit condensateur de surtension (18) est adapté pour maintenir un niveau de tension d'environ 4,5 volts après que ladite électrode de commande (38) dudit transistor (14) a été déchargée.

18. Procédé pour conserver un niveau de tension prédéterminé proche d'un niveau d'alimentation de tension (VDD) aux bornes d'un condensateur de surtension (18) comprenant les étapes consistant à :
- élever la tension d'un noeud (12) jusqu'à un niveau de surtension sensiblement au dessus du niveau d'alimentation de tension ;
- décharger une seconde électrode (26) du condensateur de surtension (18) jusqu'à un premier niveau de tension (TERRE) ;
- extraire une charge dudit noeud à travers un transistor (14) vers une première électrode (16) du condensateur de surtension (18) sensible à ladite étape de décharge de la seconde électrode (26) de manière à établir un second niveau de tension sur la première électrode (16), le premier niveau de tension étant choisi de telle sorte que la différence entre le premier niveau de tension et le second niveau de tension soit égale ou légèrement supérieure au niveau de tension prédéterminé;et
- décharger par la suite l'électrode de commande (38) du transistor (14) jusqu'à un niveau de tension inférieur à la tension de seuil du transistor (14) pour isoler le condensateur de surtension (18) du noeud (12), de telle sorte que le niveau de tension prédéterminé soit maintenu dans le condensateur de surtension (18) pendant une durée de temps étendue.

19. Procédé selon la revendication 18, comportant de plus les étapes de :
- augmentation de la tension d'une seconde électrode (30) d'un second condensateur (32) jusqu'au niveau d'alimentation de tension ;
- en réponse à ladite étape d'augmentation de niveau de tension de ladite seconde électrode (30), augmenter le niveau de tension d'une première électrode (34) du second condensateur (32) jusqu'à un niveau de surtension au dessus du niveau d'alimentation de tension; et
- transmission du niveau de surtension à partir de la première électrode (34) du second condensateur (32) vers l'électrode de commande (38) du transistor (14) de telle sorte que le courant puisse circuler entre le condensateur de surtension (18) et le noeud (12).

20. Procédé selon l'une des revendications 18 et 19, comprenant de plus l'étape consistant à porter le niveau de tension de ladite électrode de commande (38) au niveau d'alimentation de tension avant ladite étape d'augmentation du niveau de tension de ladite électrode de commande (38).

21. Procédé selon l'une des revendications 19 et 20, dans laquelle ladite étape d'augmentation de tension du noeud comporte de plus l'étape d'augmentation du niveau de tension d'une seconde électrode (26) du condensateur de surtension (18) jusqu'au niveau d'alimentation de tension afin de provoquer une élévation du niveau de tension de sa première électrode (16) au dessus du niveau d'alimentation de tension.

22. Méthode selon l'une quelconque des revendications 18 et 21, comportant de plus l'étape consistant à:
- porter la tension du noeud jusqu'au niveau d'alimentation de tension ; et
- augmenter par la suite la tension de l'électrode de commande (38) du transistor (14) pour permettre au niveau de surtension d'être transféré au noeud (12).

23. Méthode selon l'une quelconque des revendications 18 à 22, comportant de plus l'étape consistant à porter la première électrode (16) du condensateur de surtension (18) au niveau d'alimentation de tension avant ladite étape d'augmentation de tension du noeud.

24. Méthode selon l'une quelconque des revendications 18 à 23, comportant l'étape consistant à décharger le noeud (12) après ladite étape de décharge de l'électrode de commande du transistor (38).
